# EUROPÄISCHE PATENTSCHRIFT

(11) **EP 3 409 676 B1**
(45) Veröffentlichungstag und Bekanntmachung des Hinweises auf die Patenterteilung: **14.10.2020**
(21) Anmeldenummer: 17173318.1
(22) Anmeldetag: 29.05.2017
(51) Int. Cl.: C07F 5/00

(54) **HERSTELLUNG VON TRIALKYLINDIUMVERBINDUNGEN IN GEGENWART VON CARBOXYLATEN**
PREPARATION OF TRAIL KYLINDIUM COMPOUNDS IN THE PRESENCE OF CARBOXYLATES
FABRICATION DE COMPOSÉS DE TRIALKYLINDIUM EN PRÉSENCE DE CARBOXYLATES

(43) Veröffentlichungstag der Anmeldung: 05.12.2018
(73) Patentinhaber: UMICORE AG & CO. KG, 63457 Hanau-Wolfgang (DE)
(72) Erfinder: SCHORN, Wolf, 76337 Waldbronn (DE); KARCH, Ralf, 63801 Kleinostheim (DE); FREY, Annika, 63457 Hanau (DE); DOPPIU, Angelino, 63500 Seligenstadt (DE); RIVAS NASS, Andreas, 64625 Bensheim (DE); WOERNER, Eileen, 61130 Nidderau (DE)

(56) Entgegenhaltungen:
- WO-A1-2014/099171

## Beschreibung

Die Erfindung betrifft Verfahren zur Herstellung von Trialkylindium, wobei die Herstellung in einem Reaktionsgemisch erfolgt, das mindestens ein Alkylindiumhalogenid, ein Trialkylaluminium, ein Carboxylat und ein Lösungsmittel enthält, wobei die Alkylreste an dem Indium und Aluminium unabhängig voneinander ausgewählt sind aus C1-C4 Alkyl.

### Stand der Technik

Trialkylindium-Verbindungen, insbesondere Trimethylindium und Triethylindium, werden bei der metallorganischen chemischen Gasphasenabscheidung (MOCVD) als Vorläuferverbindungen (Precursor) zur Herstellung von indiumbasierten Schichten eingesetzt. Das Verfahren dient insbesondere zur Herstellung von Halbleitern. Bei dem Verfahren werden gasförmige Vorläuferverbindungen in eine Reaktionskammer geleitet, in der sie untereinander oder mit weiteren Substanzen reagieren und die Reaktionsprodukte auf einem Substrat abgeschieden werden. Trialkylindium-Verbindungen sind kristalline, sublimierbare oder flüssige, destillierbare Verbindungen, die pyrophor sind und sich somit spontan in Gegenwart von Luft entzünden.

Bei der Verwendung von Trimethylindium als Vorläuferverbindung in MOCVD-Verfahren besteht das Problem, dass bereits geringfügige polare Verunreinigungen, insbesondere von Sauerstoff, aber auch von Stickstoff oder Phosphor, die Produkte inaktivieren können ("vergiften"). Für Halbleiteranwendungen sind bereits Sauerstoffverunreinigungen im ppm-Bereich nicht akzeptabel. Dies führt dazu, dass besondere Verfahren zur Herstellung von Trimethylindium bereitgestellt werden müssen, bei denen Sauerstoff- und andere Verunreinigungen nahezu völlig vermieden werden.

Klassische Verfahren zur Herstellung von Trialkylindium sind die Grignard-Reaktion aus Indium, Magnesium und Alkylhalogeniden, Salzeliminierungsreaktionen aus Indium(III)-chlorid und Methyllithium, und Transmetallierungsreaktionen aus Indium und Metallalkylverbindungen. Solche Verfahren sind zur Herstellung von Trialkylindium für MOCVD-Prozesse im Allgemeinen ungeeignet, weil Trialkylindium nicht in der erforderlichen Reinheit bereitgestellt werden kann. Dies liegt unter anderem daran, dass solche Verfahren polare Lösungsmittel wie Ether benötigen. Diese weisen eine relativ hohe Affinität zu Indium auf, was zu Komplexbildungen und zur Verunreinigung des Produktes mit Sauerstoffverbindungen führt.

Um das Problem solcher Verunreinigungen zu lösen, wurden im Stand der Technik verschiedene Verfahren vorgeschlagen, die keine sauerstoffhaltigen Lösungsmittel erfordern. So schlägt die WO2014/093419 vor, eine Vorläuferverbindung R3M2X3 mit R = Alkyl und M = Gallium, Indium oder Thallium, mit einem Reduktionsmittel umzusetzen. Als Lösungsmittel werden insbesondere Kohlenwasserstoffe eingesetzt. Nachteilig ist dabei, dass als Reaktionsmittel elementares Natrium eingesetzt wird. Natrium ist äußerst reaktiv, schwer zu handhaben und führt regelmäßig zu unerwünschten Nebenreaktionen. Gerade in einem Gemisch mit pyrophoren organometallischen Verbindungen, wie den Alkylmetalledukten und -produkten, ist der Einsatz von elementarem Natrium gefährlich und für industrielle Anwendungen wenig geeignet. In den Ausführungsbeispielen werden nur Verfahren mit Galliumverbindungen beschrieben. Die Reaktivität von Gallium und Indium ist aber bei solchen Reaktionen, die Komplexe mit Halogenen und Alkylresten betreffen, sehr unterschiedlich. Die Ausbeuten sind, soweit überhaupt angegeben, niedrig. Die Ausbeute wird auch nur in dem kruden Reaktionsgemisch, also ohne Abtrennung des Produktes, durch NMR untersucht. Daher ist unklar, ob das Produkt überhaupt abgetrennt werden kann, geschweige denn in welcher Menge und Reinheit.

Die US2006/0047132 A1 offenbart verschiedene Verfahren zur Herstellung von organometallischen Verbindungen, insbesondere auf Basis von Gallium, Indium, Aluminium und Zink, aus einer Vielzahl von Vorläuferverbindungen. Die Verfahren werden in Gegenwart von tertiären Aminen oder tertiären Phosphinen durchgeführt, die mit Metallen Addukte bilden und dadurch die Bildung der gewünschten Produkte unterstützen sollen. Dabei ist nachteilig, dass die eingesetzten niedermolekularen stickstoff- und phosphorhaltigen Verbindungen die Produkte verunreinigen, wodurch Verwendungen der Produkte zur Halbleiterherstellung mittels MOCVD ausgeschlossen werden. Eine Reinigung der Produkte durch Sublimation ist nicht oder nur unzureichend möglich, weil der Siedepunkt der eingesetzten niedermolekularen tertiären Amine oder Phosphine relativ niedrig ist. Entsprechend wird in Beispiel 12 (dem einzigen Ausführungsbeispiel, bei dem konkret eine Indiumalkylverbindung hergestellt wird) angegeben, dass der Versuch der Isolierung des Produktes im Vakuum nicht erfolgreich war. Daher konnte das krude Reaktionsprodukt, das Trimethylindium, das Aminbase-Addukt und das Lösungsmittel enthielt, nur mittels NMR untersucht werden. Offensichtlich ist ein solches Verfahren in der Praxis, wenn hochreine Produkte ohne Verunreinigungen erforderlich sind, nicht oder nur begrenzt anwendbar. Offenbart werden außerdem zwei theoretische Beispiele 7 und 8 zur Herstellung von Trimethylindium. Es wird behauptet, dass ein gutes Ergebnis erwartet würde. Dies ist unglaubwürdig, weil das in Beispiel 12 beschriebene Problem der Abtrennung des Trimethylindiums von dem kruden Reaktionsprodukt nicht gelöst ist. Es ist daher nicht zu erwarten, dass gemäß den spekulativen Beispielen 7 oder 8 eine gute Ausbeute erhalten würde, geschweige denn, dass ein Produkt mit der erforderlichen Reinheit erhalten werden könnte. Vielmehr ist zu erwarten, dass die Verfahren zur Herstellung von hochreinem Trimethylindium für MOCVD-Prozesse ungeeignet sind.

Die WO2014/099171 beschreibt Verfahren zur Herstellung von Trialkylindium-Verbindungen aus Indiumcarboxylaten und Alkylaluminium-Verbindungen. Die Reaktionsausbeuten des sublimierten Trimethylindiums sind mit etwa 50 bis 55% niedrig. Nachteilig ist auch, dass niedermolekulare Komponenten in den Reaktionsgemischen vorhanden sind, wie Isohexan oder Triacetat, die zu einer Verunreinigung des Produkts bei der Sublimation führen. In einer Verfahrensvariante wird das niedermolekulare Lösungsmittel nach der Reaktion durch ein höhersiedendes Lösungsmittel ersetzt, wodurch das Verfahren relativ umständlich ist.

Die WO2015/024894 offenbart ein Verfahren zur Herstellung von Trialkylindium aus Vorläuferverbindungen der Formel R3In2Cl3, wobei R ein Alkylrest mit 1 bis 4 Kohlenstoffatomen ist. Die Reaktion erfolgt in einem mehrstufigen Verfahren, bei dem zunächst mit Alkyllithium ein Lithiumtetraalkylindat erzeugt wird, das anschließend mit einer Indiumchlorid-Komponente umgesetzt wird. Obwohl die Ausbeuten relativ hoch sind, wäre es grundsätzlich wünschenswert, ein einfacheres Verfahren bereitzustellen. Auch wird bei dem Verfahren Diethylether eingesetzt, was zu Sauerstoffverunreinigungen des Produktes durch Bildung von Addukten führen kann.

Die US-Patente 5,756,786 und US 6,770,769 B2 betreffen Verfahren zur Herstellung von Trimethylindium aus Indiumtrichlorid und Trimethylaluminium in Gegenwart von Kaliumfluorid. Die Ausbeuten liegen bei etwa 56% und sind daher verbesserungsbedürftig. Das Nebenprodukt Dimethylaluminiumfluorid weist einen relativ niedrigen Siedepunkt auf und tritt daher bei der Aufreinigung des Produktes im Vakuum als Verunreinigung auf. Bei dem Verfahren wird ein hoher Überschuss von Kaliumfluorid eingesetzt. Allgemein ist die Handhabung von Fluoriden bei industriellen Prozessen problematisch, da die Aufbereitung aufwendig und kostenintensiv ist. Auch müssen die Reaktionsrückstände aufwendig deaktiviert werden, weil Teile der Nebenprodukte, wie K[Me2AlF2], eine hohe Reaktivität aufweisen. Ein weiterer Nachteil ist, dass die festen Edukte InCl3 und KF polymere Strukturen aufweisen. Sie sind daher im unpolaren Lösungsmittel Squalan nicht oder nur sehr schlecht löslich. Daher muss die Reaktion bei relativ hohen Temperaturen oberhalb 100°C durchgeführt werden, was angesichts der exothermen Reaktion und der eingesetzten pyrophoren Verbindungen zu Sicherheitsproblemen führt. Zudem kann die Reaktion wegen der schlecht löslichen Edukte, die inhomogen als Feststoffe verteilt vorliegen, nur unzureichend kontrolliert werden. Das Verfahren ist auch relativ ineffizient, weil ein hoher (3-facher) molarer Überschuss der Aluminiumverbindung gegenüber der Indiumverbindung erforderlich ist. Aus den genannten Gründen ist das Verfahren kaum geeignet, großtechnisch angewendet zu werden.

Insgesamt besteht also ein Bedarf nach neuen effizienten und einfachen Verfahren zur Herstellung von Trialkylindium in hoher Ausbeute und Reinheit.

### Aufgabe der Erfindung

Der Erfindung liegt die Aufgabe zugrunde, Verfahren bereitzustellen, welche die oben beschriebenen Nachteile überwinden. Es soll ein Verfahren zur Herstellung von Trialkylindium bereitgestellt werden, bei dem das Produkt in hoher Ausbeute und hoher Reinheit erhalten wird. Insbesondere soll vermieden werden, dass unerwünschte Verunreinigungen in das Produkt gelangen, die sich nachteilig in Folgeprozessen, wie MOCVD-Anwendungen, auswirken. Insbesondere sollen Verunreinigungen mit Sauerstoff, aber auch mit Stickstoff, Phosphor oder anderen Metallen, vermieden werden. Das Verfahren soll möglichst einfach durchführbar sein und möglichst wenig Reaktionsschritte aufweisen. Die Ausgangsstoffe sollen möglichst einfach und in großen Mengen verfügbar sein und möglichst einfach handhabbar sein. Insgesamt soll das Verfahren möglichst einfach, effizient und kostengünstig durchführbar sein.

### Offenbarung der Erfindung

Überraschenderweise wird die der Erfindung zugrunde liegende Aufgabe gelöst durch Verfahren gemäß den Patentansprüchen.

Gegenstand der Erfindung ist ein Verfahren zur Herstellung von Trialkylindium, wobei die Herstellung in einem Reaktionsgemisch erfolgt, das mindestens ein Alkylindiumhalogenid, ein Trialkylaluminium, ein Carboxylat und ein Lösungsmittel enthält.

Die Alkylreste sind unabhängig voneinander ausgewählt aus C1-C4 Alkyl. Die Alkylreste können linear oder verzweigt sein. Es ist dabei besonders bevorzugt, dass die Alkylreste ausgewählt sind aus Methyl oder Ethyl. Besonders bevorzugt ist der Alkylrest Methyl.

Die Edukte Alkylindiumhalogenid und Trialkylaluminium weisen Alkylreste auf. Diese können unabhängig voneinander ausgewählt sein und somit verschieden sein. Es ist jedoch besonders bevorzugt, dass alle Alkylreste in dem Reaktionsgemisch identisch sind. Dies bedeutet, dass sowohl das Alkylindiumhalogenid als auch das Trialkylaluminium dieselben Alkylreste aufweisen, so dass ein Trialkylindium mit identischen Alkylresten erhalten wird. Besonders bevorzugt ist eine Reaktion, bei der ein Methylindiumhalogenid und Trimethylaluminium zur Herstellung von Trimethylindium eingesetzt werden. Ebenfalls bevorzugt ist eine Reaktion, bei der ein Ethylindiumhalogenid und Triethylaluminium zur Herstellung von Triethylindium eingesetzt werden.

Das Alkylindiumhalogenid weist bevorzugt ein Halogenid auf, das ausgewählt ist aus Fluorid, Chlorid, lodid und Bromid. Besonders bevorzugt ist das Halogenid Chlorid. Allgemein ist bei solchen Reaktionen Chlorid bevorzugt, da die entsprechenden Verbindungen auf relativ einfache Weise und kostengünstig verfügbar sind.

In einer bevorzugten Ausführungsform ist das Halogenid Chlorid und/oder das Alkyl ist Methyl. Besonders bevorzugt ist das Halogenid Chlorid und das Alkyl ist Methyl. Bei dieser Ausführungsform betrifft die Erfindung ein Verfahren zur Herstellung von Trimethylindium aus einem Reaktionsgemisch, das ein Methylindiumchlorid und Trimethylaluminium enthält.

Das Reaktionsgemisch enthält mindestens ein Alkylindiumhalogenid. Mit dem Oberbegriff "Alkylindiumhalogenid" wird eine Gruppe von Verbindungen der Formel RalnbXc bezeichnet, die aus Indium, Alkyl und Halogen bestehen. Der Begriff bedeutet daher nicht, dass Alkyl, Indium und Halogenid im Verhältnis 1:1:1 vorliegen. Bei Alkylindiumhalogeniden bildet das Metall Indium mit den Alkyl- und Halogenidresten einen metallorganischen Komplex oder ein Salz davon. Allgemein liegen solche metallorganischen Indiumhalogenide oft als Gemisch verschiedener Verbindungen vor, die miteinander im Gleichgewicht stehen. Dabei sind die molaren Verhältnisse a:b:c von Alkyl, Indium und Halogenid insgesamt oft nicht ganzzahlig, und sie können auch je nach dem konkreten Herstellungsverfahren variieren. Die Verbindungen sind eher Polymere mit variablen Strukturen. Die konkreten Strukturen sind dabei teilweise nicht bekannt, da sie im Stand der Technik noch nicht vollständig geklärt wurden. Erfindungsgemäß ist jedoch wesentlich, dass ein organometallischer Komplex verwendet wird, der Alkyl- und Halogenidreste aufweist. Die molaren Verhältnisse können ohne weiteres durch Elementaranalyse oder NMR-Untersuchungen ermittelt werden.

In einer bevorzugten Ausführungsform weist das Alkylindiumhalogenid die Formel RalnbXc auf, wobei R ausgewählt ist aus C1-C4 Alkyl; wobei X ausgewählt ist aus Cl, Br und I; und wobei a = 1-2, b = 1 und c = 1-2 ist. Bevorzugt ist dabei R = Methyl oder Ethyl und X = Cl. Somit können die molaren Stoffmengenverhältnisse von R:In:X zwischen 1:1:2 und 2:1:1 variieren. In der Praxis werden solche Alkylindiumhalogenide auch als Gemische von Verbindungen der Formel R2InX und RInX2 beschrieben. Auch bei diesen Verbindungen variieren die konkreten Zusammensetzungen oft innerhalb der genannten Bereiche, wobei die konkrete Stöchiometrie vom Herstellungsverfahren abhängt.

In einer bevorzugten Ausführungsform ist das Alkylindiumhalogenid ein Alkylindiumsesquichlorid (R3In2Cl3). Die Verbindung R3In2Cl3 kann auch als äquimolares Gemisch aus R2InCl und RInCl2 beschrieben werden. In der Praxis liegen solche Verbindungen regelmäßig nicht genau im angegebenen idealen molaren Verhältnis vor. So wurde beispielsweise gefunden, dass bei den Methylchlorverbindungen das molare Verhältnis von Methyl zu Chlorid ungefähr bei 2:3 liegen kann. Die Summenformel kann dabei als Me2,4In2Cl3,6 angegeben werden.

Verfahren zur Herstellung von Alkylindiumhalogeniden sind im Stand der Technik bekannt. Sie beruhen oft auf der Reaktion von Indiumhalogeniden mit Alkylhalogeniden. Die Herstellung von Alkylindiumsesquichlorid wird beispielsweise in der WO2015/024894A1 beschrieben. Weitere Verfahren werden in Gynane et al., J. Organomet. Chem., 40, 1972, C9-C10, oder Gynane et al., J. Organomet. Chem., 81, 1974, 329-334, offenbart. In US 5,817,847 wird die Reaktion von MeCl mit geschmolzenem Indium beschrieben, wobei in Abhängigkeit von der Reaktionszeit MeInCl2 oder Me2InCl erhalten wird (Me = Methyl).

Das Reaktionsgemisch weist mindestens ein Trialkylaluminium auf, wobei Alkyl bevorzugt Methyl oder Ethyl ist. Trialkylaluminium-Verbindungen sind organometallische Verbindungen der allgemeinen Formel AIR3. Solche Verbindungen liegen im allgemeinen als Dimere oder Polymere vor, bei denen jedes Aluminiumatom mehr als dreifach koordiniert ist. Das Trialkylaluminium dient bei dem erfindungsgemäßen Verfahren dazu, Alkylreste zur Reaktion mit der Indiumverbindung bereitzustellen. Insgesamt gehen bei der Reaktion Alkylreste von der Aluminiumverbindung auf die Indiumverbindung über. Solche Verfahren werden auch als Transalkylierung bezeichnet.

Das Reaktionsgemisch weist mindestens ein Carboxylat auf. Als Carboxylate werden Salze von Carbonsäuren bezeichnet. Carbonsäuren sind organische Verbindungen, die eine oder mehrere Carboxygruppen (-COOH) tragen. Somit ist eine ionische Verbindung enthalten, die mindestens eine deprotonierte Carboxygruppe aufweist. Bevorzugt wird dem Reaktionsgemisch ein Carboxylatsalz zugegeben, das in dem Reaktionsgemisch zumindest teilweise dissoziiert. Es ist auch denkbar, eine Carbonsäure einzusetzen, die zumindest teilweise in dem Reaktionsgemisch neutralisiert wird.

Erfindungsgemäß wurde überraschenderweise festgestellt, dass die Herstellung von Trialkylindium deutlich effizienter ist, wenn eine Transalkylierung in Gegenwart eines Carboxylats durchgeführt wird. In Gegenwart von Carboxylaten können hohe Ausbeuten erzielt werden, wobei gleichzeitig hochreine Produkte erhalten werden. Die Produkte wiesen keine nachweisbaren Verunreinigungen durch Sauerstoff auf. Außerdem wird die Reaktion durch das Carboxylat effizienter und die Menge des eingesetzten Trialkylaluminiums kann verringert werden. Ohne an eine Theorie gebunden zu sein, wird angenommen, dass das Carboxylat mit den Edukten intermediäre Komplexe oder Reaktionsprodukte bildet, welche die Gesamtreaktion positiv beeinflussen.

Die Carboxylate werden neben den organometallischen Indium- und Aluminiumverbindungen als weitere Komponente eingesetzt, d.h. sie werden also nicht als Bestandteile von organometallischen Indium- und Aluminiumverbindungen eingesetzt. Das Verfahren unterscheidet sich somit signifikant von dem der WO2014/099171A1, bei dem Indiumcarboxylate als Edukte eingesetzt werden.

Die Carboxylate können beispielsweise eine, zwei oder mehr Carboxygruppen pro Molekül aufweisen. In einer bevorzugten Ausführungsform ist das Carboxylat ein Monocarboxylat. Es wurde gefunden, dass die Reaktion mit Monocarboxylaten deutlich effizienter ist. Ohne durch eine Theorie gebunden zu sein, wird angenommen, dass bei zwei- oder höherwertigen Carboxylaten eine Chelatisierung stattfinden kann, die den Reaktionsablauf beeinträchtigt.

Das Carboxylat ist in einer bevorzugten Ausführungsform das Carboxylat einer Carbonsäure der Formel R'-COOH, wobei R' ein Kohlenwasserstoffrest ist. Der Kohlenwasserstoffrest kann ein Alkyl-, Aryl- oder Ararylrest mit 1 bis 20 Kohlenstoffatomen sein. Die Carbonsäuren können linear oder verzweigt sein. Solche Kohlenwasserstoffcarboxylate sind bevorzugt, da sie mit dem Reaktionsgemisch kompatibel sind und zu einer guten Löslichkeit und Reaktion der organometallischen Komponenten führen. Dabei ist das Lösungsmittel bevorzugt ein Kohlenwasserstoff. Bevorzugt ist auch die Abwesenheit weiterer polarer Verbindungen, welche die Reaktion beeinträchtigen könnten oder das Produkt verunreinigen könnten.

Erfindungsgemäß wurde überraschenderweise gefunden, dass die Reaktion sehr effizient in Gegenwart von hochsiedenden Carboxylaten verläuft. Dies ist vorteilhaft, weil das Trialkylindiumprodukt durch Sublimation abgetrennt werden kann, ohne dass solche hochsiedenden Carboxylate in das Produkt gelangen. In einer bevorzugten Ausführungsform ist daher das Carboxylat das einer Carbonsäure der Formel R'-COOH, wobei R' ein Kohlenwasserstoffrest ist, der ein Alkyl-, Aryl- oder Ararylrest sein kann, und der mindestens 5, bevorzugt 5 bis 20 Kohlenstoffatome aufweist. Bevorzugt weist der Rest R' 5 bis 15, insbesondere 5 bis 12, besonders bevorzugt 7 Kohlenstoffatome auf. Die Carbonsäuren sind dabei besonders bevorzugt Alkansäuren. Diese können linear oder verzweigt sein, wobei verzweigte Carbonsäuren bevorzugt sein. Die den Carboxylaten zugrunde liegenden Carbonsäuren weisen relativ hohe Siedepunkte auf, die im allgemeinen oberhalb 200°C liegen, und führen nicht oder nur in geringem Maße zu Verunreinigungen des durch Sublimation gereinigten Produktes.

Das Carboxylat ist bevorzugt das Salz eines Metalls. In einer bevorzugten Ausführungsform weist das Metall die Oxidationsstufe 1 oder 2 auf. Insbesondere ist das Metall ein Alkali- oder Erdalkalimetall. Besonders bevorzugt wird ein Salz eines Alkalimetalls eingesetzt, insbesondere ein Natrium- oder Kaliumcarboxylat.

Bevorzugt ist das Carboxylat ein solches der Formel [R'COO]xM, wobei M aus einwertigen und zweiwertigen Anionen, bevorzugt Metallen, ausgewählt ist, und x = 1 oder 2 ist. Dabei ist x = 2, wenn M ein zweiwertiges Metall ist. Bevorzugt sind die Metalle Alkalimetalle oder Erdalkalimetalle, da solche Metalle im Allgemeinen gut löslich und verfügbar sind. Besonders bevorzugt sind Li, Na, K, Mg oder Ca, insbesondere Na oder K.

In einer bevorzugten Ausführungsform weist das Carboxylat die Formel R'-COOM auf, wobei M ausgewählt ist aus Alkalimetall oder Erdalkalimetall, wobei R' ein Kohlenwasserstoffrest mit 6 bis 15 Kohlenstoffatome, insbesondere mit 6 bis 12 Kohlenstoffatomen ist. Besonders bevorzugt ist das Carboxylat ein lineares oder verzweigtes Octanoat, insbesondere ein 2-Ethylhexanoat, insbesondere Natrium-2-Ethylhexanoat, oder n-Octanoat.

In einer bevorzugten Ausführungsform weist die dem Carboxylat zugrunde liegende Carbonsäure einen Siedepunkt größer 200°C, insbesondere größer 250°C auf. Carboxylate mit solchen hohen Siedepunkten verbleiben bei der Abtrennung von Trialkylindium, insbesondere Trimethylindium, im Reaktionsgemisch. So weist beispielsweise Octansäure einen Siedepunkt von etwa 237°C auf.

Die Reaktion findet in einem Lösungsmittel statt. Dieses wird so ausgewählt, dass die Edukte und das Carboxylat möglichst gut gelöst oder zumindest suspendiert werden können. Es ist dabei bevorzugt, dass das Lösungsmittel unpolar ist. Insbesondere ist bevorzugt, dass das Lösungsmittel keine polaren Gruppen aufweist, wie sauerstoff-, stickstoff- oder phosphorhaltige Gruppen und/oder O-, N- oder P-Atome.

In einer bevorzugten Ausführungsform enthält das Lösungsmittel Kohlenwasserstoffe. Besonders bevorzugt besteht es aus Kohlenwasserstoffen. Es wurde gefunden, dass die Reaktion besonders effizient in Kohlenwasserstoffen durchgeführt werden kann. Die Kohlenwasserstoffe können dabei aliphatische oder aromatische Kohlenwasserstoffe sein. Dabei werden bevorzugt Alkane eingesetzt. Diese können beispielsweise ausgewählt sein aus Pentan, Cyclohexan, Decan, Heptan, Hexan, Methylcyclohexan, Nonan, Octan oder längerkettigen Kohlenwasserstoffen mit 10 bis 15 Kohlenstoffatomen. Die aromatischen Kohlenwasserstoffe können beispielsweise ausgewählt sein aus Benzol, Toluol und Xylol, oder aus anderen mono- oder polycyclischen Aromaten, die substituiert oder unsubstituiert sein können. Es können auch Gemische der genannten Kohlenwasserstoffen eingesetzt werden.

In einer bevorzugten Ausführungsform besteht das Lösungsmittel aus Kohlenwasserstoffen mit einem Siedepunkt größer 200°C, insbesondere größer 300°C oder größer 400°C. Bei dieser Ausführungsform ist in hohem Maße vorteilhaft, dass das Lösungsmittel bei der Aufreinigung des Produktes durch Sublimation nicht oder nur in geringem Maße destilliert wird und das Produkt verunreinigt. Dabei ist es besonders bevorzugt, dass das Lösungsmittel einen Siedepunkt oberhalb 400°C aufweist. Besonders geeignet ist Squalan, das einen Siedepunkt von 450°C aufweist.

Ohne an eine Theorie gebunden zu sein, könnte das Verfahren gemäß der folgenden Reaktionsgleichung (I) ablaufen, wenn als Ausgangsstoffe Trimethyldiindiumtrichlorid (Methylindiumsesquichlorid), Trimethylaluminium und Natrium-2-ethylhexanoat eingesetzt werden:

2 Me3In2Cl3 + 3 Me3AI + 6 Na(2-EH) → 4 Me3In + 3 MeAl(2-EH)2 + 6 NaCl (I)

Die Gleichung (I) beschreibt eine ideale und theoretische Reaktion. Wie oben ausgeführt wurde, weisen Alkylindiumhalogenide in der Praxis regelmäßig Stöchiometrien auf, die beispielsweise von dem idealen Verhältnis 3:2:3 abweichen. Außerdem werden in der Praxis auch Nebenprodukte, wie Carboxylate, in Form von Komplexen erhalten.

Zur Durchführung der Reaktion wird ein Reaktionsgemisch bereitgestellt. Dieses enthält das Alkylindiumhalogenid, das Trialkylaluminium, ein Carboxylat und ein Lösungsmittel, wobei jeweils auch Gemische dieser Komponenten eingesetzt werden können. Das Lösungsmittel wird bevorzugt so ausgewählt, dass die Edukte darin möglichst homogen verteilt vorliegen, bevorzugt als Lösung oder zumindest als möglichst feine Dispersion. Dabei erfolgt die Vermischung der Ausgangsstoffe so, dass eine möglichst effiziente Reaktion erfolgt und Nebenreaktionen insbesondere zu Beginn der Reaktion vermieden werden.

Es ist ein Vorteil des Verfahrens, dass die Reaktion sehr effizient verläuft. Dies führt dazu, dass nur eine relativ geringe Menge des Trialkylaluminiums eingesetzt werden muss, was insgesamt zu einer erheblichen Einsparung von Kosten führt. Beispielsweise werden gemäß der oben angegebenen Reaktionsgleichung für die Umwandlung von 4 mol Indium lediglich 3 mol Aluminium benötigt. Dagegen ist bei herkömmlichen Verfahren oft ein relativ hoher Überschuss von Aluminium erforderlich. Allerdings kann es erfindungsgemäß vorteilhaft sein, einen Überschuss der Aluminiumverbindung einzusetzen, um die Ausbeute zu verbessern. In einer bevorzugten Ausführungsform ist das molare Verhältnis von Indium und Aluminium in dem Reaktionsgemisch zwischen 3:2 und 1:2, insbesondere zwischen 3:2 und 2:3. Besonders bevorzugt ist das molare Verhältnis zwischen 3:2 und 1:1, insbesondere zwischen 4:3 und 1:1. Allgemein ist es bevorzugt, dass das Reaktionsgemisch im molaren Verhältnis mehr Indium als Aluminium enthält.

Allgemein ist es bevorzugt, einen molaren Überschuss von Carboxylat gegenüber dem Indium einzusetzen, um die Ausbeute zu verbessern. Das molare Verhältnis des Carboxylats zu Indium in dem Reaktionsgemisch kann beispielsweise zwischen 1:1 und 5:1, insbesondere zwischen 2:1 und 4:1 liegen, besonders bevorzugt zwischen 3:2 und 3:1. Dies ist im Allgemeinen aus Effizienzgründen unkritisch, da Carboxylatsalze einfach und kostengünstig verfügbar sind.

Die Reaktion kann beispielsweise bei einer Temperatur von 25°C bis 200°C durchgeführt werden. Es ist aber bevorzugt, dass die Reaktion bei einer Temperatur kleiner 100°C, insbesondere kleiner 80°C oder kleiner 70°C, durchgeführt wird. Bevorzugt wird die Reaktion bei einer Temperatur im Bereich von 25°C bis 100°C durchgeführt, insbesondere im Bereich von 30°C bis 80°C oder von 50°C bis 70°C. Erfindungsgemäß wurde gefunden, dass bereits bei einer Temperatur von etwa 60°C eine sehr hohe Ausbeute erreicht werden kann.

Es ist in hohem Maße vorteilhaft, dass erfindungsgemäß eine effiziente Reaktion bereits bei solchen relativ niedrigen Temperaturen stattfindet. Zum einen sind die eingesetzten organometallischen Verbindungen auf Basis von Indium im Allgemeinen thermisch labil. So neigt Trimethylindium dazu, sich oberhalb 120°C exotherm und unter hoher Druckentwicklung zu zersetzen. Daher ist es für die Produktausbeute und die Produktqualität vorteilhaft, dass das Verfahren bei relativ niedrigen Temperaturen durchgeführt werden kann. Zum anderen sind sowohl die eingesetzten als auch die herzustellenden organometallischen Verbindungen im Allgemeinen pyrophor. Durch Einstellung einer niedrigen Reaktionstemperatur kann daher das Gefährdungspotenzial, gerade bei der Anwendung im industriellen Maßstab, erheblich gesenkt werden.

Die Reaktion wird über einen Zeitraum durchgeführt, bis die Edukte vollständig oder weitgehend reagiert haben. Beispielsweise kann die Reaktion über einen Zeitraum von 20 min bis 20 h, insbesondere zwischen 30 min und 8 h oder zwischen 30 min und 4 h durchgeführt werden. Da die Reaktion relativ effizient verläuft, können Reaktionszeiten kleiner 5 h oder kleiner 3 h ausreichend sein.

Die Reaktion erfolgt bevorzugt unter strengem Ausschluss von Luft und Wasser. Anderenfalls würden unerwünschte Nebenreaktionen stattfinden, weil das Produkt Trialkylindium und auch das Edukt Trialkylaluminium sehr pyrophor sind.

Bevorzugt erfolgt die Reaktion zu Trialkylindium nach Vermischung sämtlicher Ausgangsstoffe in einem einzigen Schritt, also ohne dass Intermediate isoliert werden müssen oder dass danach weitere reaktive Verbindungen hinzugefügt werden, wie Lithiumverbindungen.

Nach Beendigung der Reaktion wird das Trialkylindium bevorzugt abgetrennt. In einer bevorzugten Ausführungsform wird das Trialkylindium durch Sublimation abgetrennt. Die Sublimation erfolgt bevorzugt im Vakuum und bei erhöhter Temperatur, beispielsweise bei 100°C bis 200°C. Gemäß bekannten Verfahren wird das feste Trialkylindium in einem gekühlten Bereich als Sublimat erhalten. Allgemein kann das gereinigte Trialkylindium nach üblichen Verfahren weiter aufgereinigt werden, beispielsweise durch Trocknen oder erneute Sublimation.

Die Edukte können in beliebiger Reihenfolge vermischt werden. In einer bevorzugten Ausführungsform umfasst die Reaktion die folgenden Schritte:
(a) Bereitstellen eines Gemisches, welches das Alkylindiumhalogenid, das Carboxylat und das Lösungsmittels enthält, gefolgt von
(b) Zugabe des Trialkylaluminiums.

Es wurde gefunden, dass die Reaktion besonders effizient verläuft, wenn das Trialkylaluminium zuletzt zugegeben wird. Dabei ist es bevorzugt, das Trialkylaluminium kontrolliert über einen längeren Zeitraum zuzugeben, beispielsweise durch Zutropfen. Die Geschwindigkeit der Zugabe wird so eingestellt, dass die Reaktion insgesamt kontrolliert verläuft. Bevorzugt kann das Trialkylaluminium kontinuierlich reagieren und akkumuliert nicht in dem Reaktionsgemisch. Insbesondere wird die Reaktion so eingestellt, dass während der Zugabe des Trialkylaluminiums die Temperatur konstant bleibt. Die Zugabe des Trimethylaluminium kann beispielsweise über einen Zeitraum von 30 min bis 5 h, insbesondere zwischen 30 min und 3 h erfolgen. Es wurde gefunden, dass bei einer solchen Reaktionsführung Nebenreaktionen vermieden werden können und die Ausbeute besonders hoch ist.

In einer weiteren Ausführungsform umfasst die Reaktion die folgenden Schritte:
(a1) Bereitstellen eines Gemisches, welches das Trialkylaluminium, das Carboxylat und das Lösungsmittels enthält, gefolgt von
(b1) Zugabe des Alkylindiumhalogenids.

Dabei ist es bevorzugt, das Alkylindiumhalogenid kontrolliert über einen längeren Zeitraum zuzugeben, beispielsweise durch Zutropfen, in Analogie zu dem oben beschriebenen Verfahren mit den Schritten (a) und (b). Bei dieser Verfahrensführung wird ausgenutzt, dass Alkylindiumhalogenide oft relativ niedrige Schmelzpunkte aufweisen und daher auch in flüssiger Form zugegeben werden können. So weist das in den Ausführungsbeispielen eingesetzte Methylindiumchlorid beispielsweise einen Schmelzpunkt von etwa 130°C auf und könnte in flüssiger Form zugetropft werden. Dies ist ein weiterer Vorteil gegenüber der Verwendung von InCl3 gemäß dem Stand der Technik, welches einen deutlich höheren Schmelzpunkt besitzt.

Nach den Schritten (a) und (b) bzw. (a1) und (b1) erfolgt bevorzugt Schritt (c) der Reinigung des Trialkylindiums durch Sublimation.

Bei der Reaktion kann das Alkylindiumhalogenid in isolierter Form eingesetzt werden. Es ist auch möglich, das Alkylindiumhalogenid in einem vorhergehenden Schritt herzustellen. Dabei kann das Alkylindiumhalogenid entweder in einem weiteren Zwischenschritt aufgereinigt werden, oder die weitere Umsetzung zu Trialkylindium findet in demselben Reaktionsgefäß statt. Beispielsweise kann das Alkylindiumhalogenid, wie ein Alkylindiumsesquichlorid, durch Reaktion von elementarem Indium mit Alkylhalogeniden bei erhöhtem Druck und einer Temperatur von 150 bis 200°C hergestellt werden. Das so hergestellte Reaktionsprodukt kann direkt mit dem Carboxylat und gegebenenfalls dem Lösungsmittel vermischt werden, gefolgt von der Zugabe von Trialkylaluminium, wodurch die Reaktion zu Trialkylindium beginnt. Es ist dabei denkbar, das Alkylindiumhalogenid bereits in dem für die weitere Reaktion benötigten Lösungsmittel herzustellen.

In einer bevorzugten Ausführungsform enthält das Reaktionsgemisch keine Komponenten, also Edukte, Carboxylate und Lösungsmittel, die einen Siedepunkt kleiner 200°C, bevorzugt kleiner 250°C oder kleiner 300°C aufweisen. Dies ist besonders vorteilhaft, weil solche hochsiedenden Verbindungen bei der abschließenden Sublimation des Trialkylindiums nicht oder nur in äußerst geringem Maße verschleppt werden.

In einer bevorzugten Ausführungsform sind abgesehen von dem Alkylindiumhalogenid, Trialkylaluminium, Carboxylat und Lösungsmittel keine weiteren Verbindungen in dem Reaktionsgemisch enthalten. In einer weiteren Ausführungsform kann das Reaktionsgemisch Additive enthalten.

In weiteren Ausführungsformen wird dem Reaktionsgemisch (abgesehen von einem Inertgas) keine Verbindung zugesetzt, die Stickstoff oder Phosphor enthält, insbesondere keine Amine oder Phosphine. Bevorzugt wird neben Carboxylaten keine weitere Verbindung zugegeben, die Sauerstoff enthält. Bevorzugt wird keine Verbindung zugegeben, die ausgewählt ist aus elementaren Metallen und Metallhalogeniden, insbesondere Indiumtrihalogenid oder Aluminiumhalogeniden.

In einer bevorzugten Ausführungsform ist die Ausbeute an Trialkylindium größer 80%, bezogen auf die eingesetzte Menge Indium. Besonders bevorzugt ist die Ausbeute größer 85%, größer 90% oder mindestens 95%. Die Ausbeute bezieht sich insbesondere auf die Menge an Trialkylindium nach der Sublimation aus dem Reaktionsgemisch. Solche hohen Ausbeuten bei der Herstellung von Trialkylindium sind unüblich und werden mit herkömmlichen Reaktionen im Allgemeinen nicht erreicht.

Die Reinheit des Trialkylindiums, das in dem Verfahren erhalten wird, ist bevorzugt mindestens 99,99 Gew.%, insbesondere mindestens 99,999 Gew.%, besonders bevorzugt mindestens 99,9999 Gew.%. Es wurde gefunden, dass solche außerordentlich reinen Produkte mit dem Verfahren erhältlich sind. Bevorzugt bezieht sich die Reinheit bereits auf das Produkt, das unmittelbar durch Sublimation aus dem Reaktionsgemisch erhalten wird.

Bevorzugt weist das Trialkylindium einen Gehalt an Sauerstoff kleiner 2 ppm, bevorzugt kleiner 1 ppm, besonders bevorzugt kleiner 0,5 ppm auf. Solche geringen Sauerstoffanteile sind bei MOCVD-Anwendungen akzeptabel. Das gemäß dem Verfahren hergestellte Trialkylindium weist somit einen außerordentlich geringen Anteil an Sauerstoff auf. Dies war unerwartet, weil Carboxylate grundsätzlich eine Sauerstoffquelle sind und nicht angenommen werden konnte, dass davon nahezu keine Rückstände in das Produkt gelangen. Erfindungsgemäß wurde gefunden, dass die Sauerstoffverunreinigungen so gering sind, dass sie mittels 1H-NMR nicht detektierbar sind. Die Nachweisgrenze dieser Methode liegt bei etwa 2 ppm.

Das hochreine Trialkylindium, das gemäß dem Verfahren erhältlich ist, eignet sich insbesondere zur Verwendung als Vorläuferverbindung bei der metallorganischen chemischen Gasphasenabscheidung (MOCVD) zur Abscheidung von Indium-haltigen Schichten. Bei diesem Verfahren wird es insbesondere in gasförmiger Form eingesetzt, wobei in der Gasphase oder auf einem Substrat eine chemische Reaktion stattfindet und Indium und/oder eine Indiumverbindung abgeschieden wird. Dabei ist es äußerst vorteilhaft, dass das Trialkylindium keine nachweisbaren Sauerstoffverunreinigungen aufweist.

Gegenstand der Erfindung ist auch ein Verfahren zu Herstellung eines indiumhaltigen Halbleiters und/oder einer indiumhaltigen Beschichtung, umfassend die Schritte:
(i) Herstellen von Trialkylindium gemäß dem erfindungsgemäßen Verfahren, und
(ii) Durchführen einer metallorganischen chemischen Gasphasenabscheidung (MOCVD), wobei das Trialkylindium als Vorläuferverbindung zur Abscheidung einer indiumhaltigen Beschichtung auf einem Substrat eingesetzt wird.

Das erfindungsgemäße Verfahren löst die beschriebene Aufgabe gegenüber dem Stand der Technik. Es wird ein neues Verfahren zur Herstellung von Trialkylindium bereitgestellt, bei dem das Produkt in hoher Ausbeute von deutlich oberhalb 90% erhalten werden kann. Das Verfahren ist daher in hohem Maße effizient und kostengünstig. Erfindungsgemäß wird auch ein Produkt von außerordentlich hoher Reinheit erhalten, bei dem Verunreinigungen von Sauerstoff nicht detektierbar sind. Das Produkt ist daher in hohem Maße als Vorläuferverbindung in CVD-Prozessen zur Herstellung von Indium-haltigen Halbleitern geeignet.

Das Verfahren weist auch hinsichtlich der Verfahrensführung zahlreiche Vorteile auf. Es ist in einem einzigen Reaktionsgemisch und einem einzigen Reaktionsschritt durchführbar und daher vergleichsweise einfach. Im Verhältnis zum Alkylindiumhalogenid, die als Edukt eingesetzt wird, kann eine relativ geringe Menge des Trialkylaluminiums eingesetzt werden. Dabei kann das molare Verhältnis von Indium zu Aluminium kleiner 1 oder sogar niedriger sein. Insgesamt kann dadurch die Menge der eingesetzten organometallischen Verbindungen, die pyrophor und schwer handhabbar sind, niedrig gehalten werden. Dies ist sowohl aus Kostengründen als auch zur Gefahrenvermeidung von Vorteil. Die Vorteile werden erreicht, weil Carboxylate eingesetzt werden, die relativ einfach verfügbar und gut handhabbar sind. Insgesamt wird ein deutlich verbessertes und vereinfachtes Verfahren zur Herstellung von Trialkylindium bereitgestellt.

Es ist ein weiterer Vorteil, dass das Verfahren ausschließlich mit Verbindungen, aber auch Nebenprodukten, durchgeführt werden kann, die relativ hohe Siedepunkte oberhalb 200°C aufweisen. Dadurch wird gewährleistet, dass bei der abschließenden Abtrennung des Trialkylindiums durch Sublimation ein hochreines Produkt erhalten wird.

### Ausführungsbeispiele

### Beispiel 1

Methylindiumchlorid der Formel Me2,4In2Cl3,6 (nachfolgend als MIC bezeichnet, hergestellt gemäß WO2015/024894A1, Beispiel 1.4) wurde in einer Inertgas-Glovebox zu Trialkylindium umgesetzt. Die Reaktion erfolgt in einem 1L Dreihalskolben mit Temperiermantel. Es werden 400 mL Squalan mit 89,9 g MIC (468 mmol bezogen auf Indium) und 135,5 g Natrium-2-ethylhexanoat (815 mmol) versetzt und mit einem KPG-Rührer kräftig gerührt. Das Gemisch wird über den Temperiermantel mit einem Thermokryostaten auf 60°C erhitzt (externe Temperaturkontrolle). Anschließend werden 29,9 g Trimethylaluminium (415 mmol) über einen Tropftrichter in einer Geschwindigkeit zugetropft, dass die Temperatur konstant bei 60°C (± 2°C) bleibt (ca. 2 h). Nach beendeter Zugabe wird der Tropftrichter gegen einen Kühler mit Kühlfinger getauscht und der Sumpf auf 120°C erhitzt. Der Kühler samt Kühlfinger wird auf -25°C gekühlt und durch Anlegen von Vakuum TMI (Trimethylindium) aus dem Reaktionsgemisch sublimiert. Dabei werden als Sublimat 70,8 g TMI (443 mmol) als kristalliner Feststoff erhalten (Ausbeute 95%). Per 1H-NMR kann keine sauerstoffbasierte Verunreinigung identifiziert werden.

### Beispiel 2:

Methylindiumchlorid der Formel Me2,4In2Cl3,6 (gemäß Beispiel 1) wurde in einer Inertgas-Glovebox zu Trialkylindium umgesetzt. In einem 1 L Dreihals-Kolben mit Temperiermantel werden als Lösungsmittel 500 g Dibenzyltoluol (Markenbezeichung Marlotherm SH, Firma Sasol, DE) mit 112,5 g Methylindiumchlorid (587 mmol bezogen auf Indium) und 168,7 g Natrium-2-ethylhexanoat (1015 mmol) versetzt und mit einem KPG-Rührer kräftig gerührt. Das Gemisch wird über den Temperiermantel mit einem Thermokryostaten auf 60°C erhitzt (externe Temperaturkontrolle). Anschließend werden 36,9 g Trimethylaluminium (512 mmol) über einen Tropftrichter in einer Geschwindigkeit zugetropft, dass die Temperatur konstant bei 60°C (± 2°C) bleibt (ca. 1 h). Nach beendeter Zugabe wird der Tropftrichter gegen einen Kühler mit Kühlfinger getauscht und der Sumpf auf 120°C erhitzt. Der Kühler samt Kühlfinger wird auf -25°C gekühlt und durch Anlegen von Vakuum TMI (Trimethylindium) aus dem Reaktionsgemisch sublimiert. Dabei werden als Sublimat 83,0 g TMI (519 mmol) als kristalliner Feststoff erhalten (88%). Per 1H-NMR kann keine sauerstoffbasierte Verunreinigung identifiziert werden.

## Patentansprüche

1. Verfahren zur Herstellung von Trialkylindium, wobei die Herstellung in einem Reaktionsgemisch erfolgt, das mindestens ein Alkylindiumhalogenid, ein Trialkylaluminium, ein Carboxylat und ein Lösungsmittel enthält, wobei die Alkylreste unabhängig voneinander ausgewählt sind aus C1-C4 Alkyl.

2. Verfahren gemäß Anspruch 1, wobei das Alkylindiumhalogenid die Formel RalnbXc aufweist, wobei R ausgewählt ist aus C1-C4 Alkyl; X ausgewählt ist aus Cl, Br, I; und wobei a = 1-2, b = 1 und c = 1-2 ist.

3. Verfahren gemäß mindestens einem der Ansprüche 1 oder 2, wobei das Halogenid Chlorid ist.

4. Verfahren gemäß mindestens einem der vorhergehenden Ansprüche, wobei das Alkyl Methyl oder Ethyl ist.

5. Verfahren gemäß mindestens einem der vorhergehenden Ansprüche, wobei das Alkylindiumhalogenid Alkylindiumsesquichlorid (R3In2Cl3) ist.

6. Verfahren gemäß mindestens einem der vorhergehenden Ansprüche, wobei das Carboxylat das einer Carbonsäure der Formel R'COOH ist, wobei R' ein Kohlenwasserstoffrest mit 1 bis 20, bevorzugt mit 5 bis 15 Kohlenstoffatomen ist.

7. Verfahren gemäß Anspruch 6, wobei das Carboxylat die Formel [R'COO]xM aufweist, wobei M ausgewählt ist aus Alkalimetall und Erdalkalimetall, und x = 1 oder 2 ist.

8. Verfahren gemäß mindestens einem der vorhergehenden Ansprüche, wobei die dem Carboxylat entsprechende Carbonsäure einen Siedepunkt größer 200°C aufweist.

9. Verfahren gemäß mindestens einem der vorhergehenden Ansprüche, wobei das Lösungsmittel aus Kohlenwasserstoffen besteht und/oder einen Siedepunkt größer 400°C aufweist.

10. Verfahren gemäß mindestens einem der vorhergehenden Ansprüche, wobei das molare Verhältnis von In : Al in dem Reaktionsgemisch zwischen 3:2 und 2:3, bevorzugt kleiner 1 ist.

11. Verfahren gemäß mindestens einem der vorhergehenden Ansprüche, wobei die Reaktion bei einer Temperatur kleiner 100°C, bevorzugt kleiner 80°C, durchgeführt wird.

12. Verfahren gemäß mindestens einem der vorhergehenden Ansprüche, wobei das Trialkylindium durch Sublimation aus dem Reaktionsgemisch abgetrennt wird.

13. Verfahren gemäß mindestens einem der vorhergehenden Ansprüche, wobei die Reaktion die folgenden Schritte umfasst:
(a) Bereitstellen eines Gemisches, welches das Alkylindiumhalogenid, das Carboxylat und das Lösungsmittels enthält, und
(b) Zugabe des Trialkylaluminiums.

14. Verfahren gemäß mindestens einem der vorhergehenden Ansprüche, wobei die Ausbeute an Trialkylindium größer 80% ist, bezogen auf die eingesetzte Menge Indium, und/oder wobei das Trialkylindium einen Gehalt an Sauerstoff kleiner 2 ppm aufweist.

15. Verfahren zu Herstellung eines indiumhaltigen Halbleiters und/oder einer indiumhaltigen Beschichtung, umfassend die Schritte:
(i) Herstellen von Trialkylindium gemäß der vorhergehenden Ansprüche, und
(ii) Durchführen einer metallorganischen chemischen Gasphasenabscheidung (MOCVD), wobei das Trialkylindium als Vorläuferverbindung zur Abscheidung einer indiumhaltigen Beschichtung auf einem Substrat eingesetzt wird.

## Claims

1. Method for preparing trialkylindium, wherein the preparation takes place in a reaction mixture that contains at least one alkylindium halide, a trialkylaluminum, a carboxylate, and a solvent, wherein the alkyl groups are chosen, independently of one another, from C1-C4 alkyl.

2. The method according to claim 1, wherein the alkylindium halide has the formula RaInbXc, wherein R is selected from C1-C4 alkyl; X is selected from CI, Br, I; and wherein a = 1-2, b = 1 and c = 1-2.

3. Method according to at least one of claims 1 to 2, wherein the halide is chloride.

4. Method according to at least one of the preceding claims, wherein the alkyl is methyl or ethyl.

5. Method according to at least one of the preceding claims, wherein the alkyl indium halide is alkyl indium sesquichloride (R3In2Cl3).

6. Method according to at least one of the preceding claims, wherein the carboxylate is that of a carboxylic acid having the formula R'COOH, wherein R' is a hydrocarbon residue having from 1 to 20, preferably from 5 to 15, carbon atoms.

7. Method according to claim 6, wherein the carboxylate has the formula [R'COO]xM, wherein M is selected from alkali metal and alkaline earth metal, and x = 1 or 2.

8. Method according to at least one of the preceding claims, wherein the carboxylic acid corresponding to the carboxylate has a boiling point greater than 200 °C.

9. Method according to at least one of the preceding claims, wherein the solvent consists of hydrocarbons and/or has a boiling point greater than 400 °C.

10. Method according to at least one of the preceding claims, wherein the molar ratio of In : Al in the reaction mixture is between 3:2 and 2:3, preferably less than 1.

11. Method according to at least one of the preceding claims, wherein the reaction is carried out at a temperature of less than 100 °C, preferably less than 80 °C.

12. Method according to at least one of the preceding claims, wherein the trialkylindium is separated out from the reaction mixture via sublimation.

13. Method according to at least one of the preceding claims, wherein the reaction comprises the following steps:
(a) providing a mixture containing the alkylindium halide, the carboxylate and the solvent, and
(b) addition of the trialkylaluminum.

14. Method according to at least one of the preceding claims, wherein the yield of trialkylindium is greater than 80 % relative to the quantity of indium that is used, and/or wherein the trialkylindium has an oxygen content of less than 2 ppm.

15. Method for preparing an indium-containing semiconductor and/or an indium-containing coating, comprising the steps of:
(i) preparing trialkylindium according to the preceding claims, and
(ii) performing a metal organic chemical vapor deposition (MOCVD), wherein the trialkylindium is used as a precursor compound for depositing an indium-containing coating on a substrate.

## Revendications

1. Procédé de fabrication de trialkylindium, dans lequel la fabrication s'effectue dans un mélange réactionnel, qui contient au moins un halogénure d'alkylindium, un trialkylaluminium, un carboxylate et un solvant, dans lequel les radicaux alkyle sont choisis indépendamment parmi les alkyles en C1 à C4.

2. Procédé selon la revendication 1, dans lequel l'halogénure d'alkylindium présente la formule RalnbXc, dans laquelle R est choisi parmi les alkyles en C1 à C4 ; X est choisi parmi Cl, Br, I ; et dans laquelle a = 1-2, b = 1 et c = 1-2.

3. Procédé selon au moins l'une quelconque des revendications 1 ou 2, dans lequel l'halogénure est le chlorure.

4. Procédé selon au moins l'une quelconque des revendications précédentes, dans lequel l'alkyle est le méthyle ou l'éthyle.

5. Procédé selon au moins l'une quelconque des revendications précédentes, dans lequel l'halogénure d'alkylindium est le sesquichlorure d'alkylindium (R3In2Cl3).

6. Procédé selon au moins l'une quelconque des revendications précédentes, dans lequel le carboxylate est l'acide carboxylique de formule R'COOH, dans laquelle R' est un radical hydrocarboné doté de 1 à 20, de préférence de 5 à 15, atomes de carbone.

7. Procédé selon la revendication 6, dans lequel le carboxylate présenté la formule [R'COO]xM, dans laquelle M est choisi parmi un métal alcalin et un métal alcalino-terreux, et x = 1 ou 2.

8. Procédé selon au moins l'une quelconque des revendications précédentes, dans lequel l'acide carboxylique correspondant au carboxylate présente un point d'ébullition supérieur à 200 °C.

9. Procédé selon au moins l'une quelconque des revendications précédentes, dans lequel le solvant est composé d'hydrocarbures et/ou présente un point d'ébullition supérieur à 400 °C.

10. Procédé selon au moins l'une quelconque des revendications précédentes, dans lequel le rapport molaire de In:Al dans le mélange réactionnel est compris entre 3:2 et 2:3, de préférence inférieur à 1.

11. Procédé selon au moins l'une quelconque des revendications précédentes, dans lequel la réaction est effectuée à une température inférieure à 100 °C, de préférence inférieure à 80 °C.

12. Procédé selon au moins l'une quelconque des revendications précédentes, dans lequel le trialkylindium est séparé par sublimation du mélange réactionnel.

13. Procédé selon au moins l'une quelconque des revendications précédentes, dans lequel la réaction comprend les étapes suivantes :
(a) fourniture d'un mélange, lequel contient l'halogénure d'alkylindium, le carboxylate et le solvant, et
(b) ajout du trialkylaluminium.

14. Procédé selon au moins l'une quelconque des revendications précédentes, dans lequel le rendement de trialkylindium est supérieur à 80 %, sur la base de la quantité d'indium utilisée, et/ou dans lequel le trialkylindium présente une teneur en oxygène inférieure à 2 ppm.

15. Procédé de fabrication d'un semi-conducteur contenant de l'indium et/ou d'un revêtement contenant de l'indium, comprenant les étapes de :
(i) fabrication de trialkylindium selon les revendications précédentes, et
(ii) exécution d'un dépôt chimique métallo-organique en phase vapeur (MOCVD), dans lequel le trialkylindium est utilisé comme composé précurseur pour le dépôt d'un revêtement contenant de l'indium sur un substrat.
